Europäisches Patentamt

**European Patent Office**

**Office européen des brevets**

(19)

(11) Veröffentlichungsnummer: **0 009 097**
**B1**

(12) **EUROPÄISCHE PATENTSCHRIFT**

(45) Veröffentlichungstag der Patentschrift: **22.06.83**

(21) Anmeldenummer: **79102643.8**

(22) Anmeldetag: **25.07.79**

(51) Int. Cl.³: **H 01 L 21/76,**
**H 01 L 21/306,**
**H 01 L 21/24**

(54) Verfahren zum Herstellen einer Isolationsstruktur in einem Halbleiterkörper.

(30) Priorität: **27.09.78 US 946007**

(43) Veröffentlichungstag der Anmeldung:
**02.04.80 Patentblatt 80/7**

(45) Bekanntmachung des Hinweises auf die Patenterteilung:
**22.06.83 Patentblatt 83/25**

(84) Benannte Vertragsstaaten:
**DE FR GB**

(56) Entgegenhaltungen:
**FR - A - 2 332 619**
**US - A - 3 919 060**
**US - A - 3 998 662**

**IBM TECHNICAL DISCLOSURE BULLETIN, Vol. 17, Nr. 6, November 1974, New York, US, M. R. POPONIAK et al.: "Enhanced diffusion in porous silicon", Seiten 1598—1599**
**IBM TECHNICAL DISCLOSURE BULLETIN, Vol. 21, Nr. 4, September 1978 New York, US, A. B. FOWLER: "Ink jet nozzle fabrication using droplit transport", Seiten 1703—1704**
**J. Electrochem. Soc., Bd. 124, Nr. 2, Febr. 1977, Seiten 285—295**

(73) Patentinhaber: **International Business Machines Corporation**
**Armonk, N.Y. 10504 (US)**

(72) Erfinder: **Brock, Geoffrey Edgar**
**126 Forest Drive**
**Mount Kisco, New York 10549 (US)**

(74) Vertreter: **Oechssler, Dietrich, Dr.rer.nat. Dipl.-Chem.**
**Schönaicher Strasse 220**
**D-7030 Böblingen (DE)**

EP 0 009 097 B1

# Verfahren zum Herstellen einer Isolationsstruktur in einem Halbleiterkörper

Die Erfindung betrifft ein Verfahren zum Herstellen einer Isolationsstruktur in einem einkristallinen Halbleiterkörper, welche sich von einer Oberfläche des Halbleiterkörpers in diesen hinein erstreckt, wobei der herzustellenden Struktur entsprechende Bereiche des Halbleiterkörpers hochdotiert, anschließend unter Umwandlung in poröses Halbleitermaterial anodisiert und schließlich oxidiert werden.

Ein Verfahren der genannten Art, bei dem Isolationsbereiche, welche dazu dienen, Siliciumbereiche voneinander zu isolieren, über die Zwischenstufe von aus porösem Silicium bestehenden Bereichen hergestellt werden, ist in dem US-Patent 3 919 060 beschrieben. Das poröse Silicium wird dabei in einem Siliciumkörper in der Weise erzeugt, daß zunächst mittels Diffusion oder Ionenimplantation hochdotierte Bereiche, welche dem gewünschten Isolationsmuster entsprechen, erzeugt werden und die hochdotierten Bereiche dann anodisch geätzt werden. Das dabei entstehende poröse Silicium wird dann zur Bildung der gewünschten Isolationsbereiche oxidiert. In solchen Fällen, in denen tief in das Halbleitermaterial hineinreichende Isolationsbereiche benötigt werden, ist es notwendig, daß die Diffusion über einen langen Zeitraum bei relativ hohen Temperaturen durchgeführt wird. Das Ergebnis ist ein Dotierungsprofil in dem Halbleiterkörper, welches einen Gradienten senkrecht zur Halbleiteroberfläche aufweist. Dieser Gradient kann bewirken, daß die Porosität des beim anodischen Ätzen entstehenden porösen Silicium nicht einheitlich ist und daß deshalb auch das bei der Oxidation entstehende poröse Siliciumdioxid auch nicht einheitlich ist.

Es ist die Aufgabe der Erfindung, ein Verfahren zum Herstellen einer aus einem durchgehend einheitlichen, dielektrischen Material bestehende Isolationsstruktur in einem Halbleiterkörper anzugeben.

Diese Aufgabe wird mit einem Verfahren der eingangs genannten Art mit den Merkmalen des kennzeichnenden Teils des Anspruchs 1 gelöst.

Zwar sind Verfahren zum Herstellen von hochdotierten Bereichen in Halbleiterkörpern, wobei ein Metall selektiv auf der Oberfläche eines Halbleiterkörpers aufgebracht und anschließend eine metallreiche Schmelze des Halbleitermaterials erzeugt wird, die man dann durch den Halbleiterkörper hindurchwandern läßt, indem ein Temperaturgradient in der gewünschten Wanderungsrichtung erzeugt wird, beispielsweise aus den US-Patentschriften 3 979 230 und 3 998 662 bekannt. Jedoch sind diese Migrationsverfahren noch nie im Zusammenhang mit der Herstellung von Isolationsbereichen angewandt worden.

Bei dem erfindungsgemäßen Verfahren erhält man anders als bei den bekannten Verfahren eine Isolationsstruktur, welche aus einem homogen zusammengesetzten und eine homogene Dichte aufweisenden Material besteht. Dies ist deshalb der Fall, weil es mit dem Migrationsverfahren möglich ist, ein Halbleitermaterial zu erhalten, welches einheitlich die Festkörpersättigungskonzentration (solid solubility) des Metalls aufweist. Die Konzentration des Metalls im Halbleitermaterial hängt von dem speziellen Metall, dem Halbleitermaterial und von der Temperatur, bei welcher der Migrationsprozeß durchgeführt worden ist, ab. Die Bereiche, welche dem Migrationsprozeß unterworfen worden sind, haben im wesentlichen einen einheitlichen Widerstand. Dadurch ist sichergestellt, daß beim anodischen Ätzen ein poröses Halbleitermaterial erhalten wird, welches bezüglich seiner Porosität und seiner Dichte einheitlich ist. Diese Einheitlichkeit ist die Voraussetzung dafür, daß auch das bei der Oxidation entstehende dielektrische Material einheitlich ist.

Es ist vorteilhaft, wenn als Metall Aluminium verwendet wird, und dieses in einer Dicke zwischen ungefähr 3 und ungefähr 5 $\mu$m aufgebracht wird. Es ist dabei günstig, daß Aluminium mittels Elektronenstrahlbedampfens ganzflächig aufzubringen und dann das Metallmuster auf photolithographischem Weg zu erzeugen.

Will man die Schmelze nur teilweise durch den Halbleiter hindurchwandern lassen, so erreicht man dies in vorteilhafter Weise dadurch, daß man wenn die gewünschte Tiefe erreicht ist, den Temperaturgradienten umkehrt.

Soll mit dem erfindungsgemäßen Verfahren eine Isolationsstruktur erzeugt werden, welche nicht vollständig durch den Halbleiterkörper hindurchgeht, so ist es vorteilhaft, wenn die Zeitdauer beim Anodisieren so gewählt wird, daß das hochdotierte Material nicht vollständig, sondern nur bis in eine festgelegte Tiefe in poröses Silicium umgewandelt wird. Dadurch wird erreicht, daß unter der fertigen Isolationsstruktur stark P-dotierte Bereiche erhalten bleiben, welche als Kanal-Stopbereiche wirken, welche die Bildung von unerwünschten Inversionskanälen verhindern.

Andere vorteilhafte Ausgestaltungen des erfindungsgemäßen Verfahrens ergeben sich aus den Unteransprüchen.

Die Erfindung wird anhand von durch Zeichnungen erläuterten Ausführungsbeispielen beschrieben.

Es zeigen:

Fign. 1 bis 3 in Querschnittsdarstellungen eine Halbleiterstruktur in verschiedenen aufeinanderfolgenden Stadien der Herstellung gemäß einer Ausführungsform des erfindungsgemäßen Verfahrens,

Fig. 1A in Aufsicht ein Halbleiterplättchen mit <100>-Orientierung unter Angabe der kri-

stallographischen {110}-Richtungen bezüglich einer geraden Kante im Plättchenrand,

Fig. 2A in Aufsicht das in der Fig. 1A gezeigte Halbleiterplättchen, in das die Lage von Subkollektorberechen und des bei dem erfindungsgemäßen Verfahren erzeugten Liniennetzes aus Aluminium bezüglich der geraden Kante im Plättchenrand eingezeichnet sind und

Fig. 4 in einer Querschnittsdarstellung eine Halbleiterstruktur in einem Stadium ihrer Her-stellung gemäß einer anderen Ausführungs-form des erfindungsgemäßen Verfahrens.

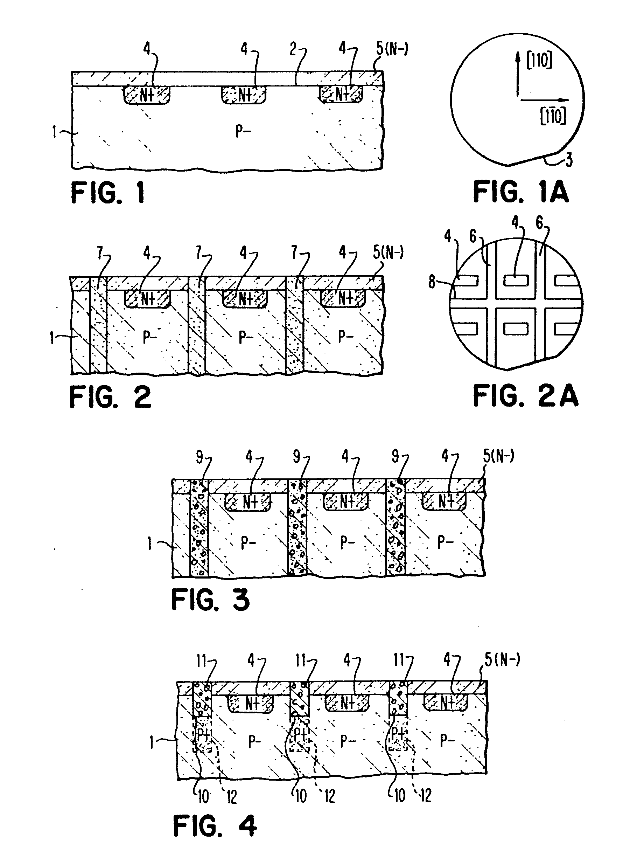

In der Fig. 1 ist im Querschnitt ein Ausschnitt aus einem Substrat 1 vom P-Typ gezeigt, welche eine größere Oberfläche 2, welche in der kristallographischen (100)-Ebene liegt, aufweist. Das Substrat 1 ist mit einer Verunreinigung vom P-Typ dotiert, wobei die Konzentration der Verunreinigung bei $10^{15}$ Atomen/cm³ liegt. Die kristallographischen <110>-und <1$\overline{1}$0>-Richtungen liegen so in der (100)-Ebene, wie es die in der Fig. 1A gezeigte Aufsichtsdarstellung zeigt. Eine gerade Kante 3 ist zuvor an dem Substratplättchen 1 angebracht worden, um in der Lage zu sein, die kristallographischen <110>- und <1$\overline{1}$0>-Rich-tungen während der nachfolgenden Fabri-kationsschritte jederzeit identifizieren zu kön-nen.

Das Plättchen 1 wird thermisch oxidiert, um eine nicht gezeigte Oberflächenschicht aus Siliciumdioxid, welche größenordnungsmäßig 160 nm dick ist, zu erzeugen. Unter Anwendung üblicher lithographischer Techniken werden in die Oxidschicht eine Subkollektordiffusionsmaske geätzt. Die Maske ist so orientiert, daß die Kanten der Subkollektorfenster parallel zu den kristallographischen <110>- und <1$\overline{1}$0>-Richtungen verlaufen.

Der Subkollektor wird in üblicher Art und Weise entweder mittels thermischer Diffusion oder mittels Ionenimplantion erzeugt. Die dabei erzeugten Bereiche 4 weisen typischerweise eine Oberflächenkonzentration von $10^{20}$ Atomen/cm³ eines Dotierungsstoffs vom N-Typ, beispielsweise von Arsen, auf. Mittels bekannter Methoden wird eine Epitaxieschicht 5 vom N-Typ, welche eine Verunreinigungskonzen-tration von ungefähr $5 \times 10^{16}$ Atomen/cm³ auf-weist und zwischen ungefähr 2 und 6 $\mu$m dick ist, auf dem die Subkollektorbereiche aufweisenden Substrat 1 aufgewachsen.

Eine Gitterstruktur von Aluminiumlinien wird als nächstes zur Festlegung der dielektrischen Isolationsbereiche, welche später im Substrat 1 gebildet werden sollen, auf der Oberfläche der Epitaxieschicht 5 erzeugt. Die Gitterstruktur wird in zwei Schritten definiert. Im ersten Schritt werden Aluminiumlinien entweder mittels eines üblichen subtraktiven Ätzverfahrens oder mittels der Abhebe(Lift-off)-Technik erzeugt. Die Linien verlaufen zwischen den Kollektorbereichen 4 in der <110>-Richtung. Bei dem subtraktiven Ätzverfahren wird Aluminium bevorzugt mittels eines Elektronenstrahlsbedampfungsverfahrens auf der Epitaxischicht 5 mit einer Dicke zwischen ungefähr 3 und ungefähr 5 $\mu$m ganzflächig aufgebracht. Anschließend wird eine Photolackschicht auf dem Aluminium aufgebracht, selektiv bestrahlt und entwickelt. Das Aluminium wird dann unter Verwendung der entwickelten Maske als Schutz für die nicht zu ätzenden Bereiche selektiv geätzt, wobei die Aluminiumlinien 6, welche in der <110>-Richtung auf der Oberfläche der Epitaxieschicht 5 zwischen den Sub-Kollektorbereichen 4 verlaufen,—wie es die Fig. 2A zeigt—übrigbleiben.

Das Plättchen wird dann in eine übliche Vorrichtung für die thermische Migration gelegt. Eine solche Vorrichtung ist beispielsweise in den oben erwähnten US-Patenten 3 979 230 und 3 998 662 beschrieben. Bei dem thermischen Migrationsverfahren wandern die Aluminiumlinien vollständig durch das Plättchen hindurch und erzeugen dadurch die in der Fig. 2 gezeigten P-dotierten Bereiche 7.

Bei thermischen Migrationsverfahren gibt es zwei Möglichkeiten, die metallreiche Schmelze durch den Halbleiterkörper hindurchwandern zu lassen. Insbesondere bei langen Halbleiterkörpern bzw. langen Wanderwegen, wird ein dem Zonenschmelzverfahren analoges Verfahren angewandt. Dabei ist der Halbleiter-körper beispielsweise mit einer Heizman-schette, welche den Halbleiterkörper induktiv beheizt, und außerdem mit einer Kühlwicklung umgeben. Wird nun auf einer Fläche des Halbleiterkörpers, welche senkrecht zu der gewünschten Wanderungsrichtung liegt, selektiv ein Metallmuster aufgebracht und erzeugt man aus diesem Metallmuster und dem Halbleitermaterial durch Wärmezufuhr eine metallreiche Schmelze, so läßt sich die Schmelze in Form einer geschmolzenen Zone durch den Halblei-terkörper hindurchbewegen, indem der Halblei-terkörper mit festgelegter Geschwindigkeit relativ zu der Heizungsmanschette und der Kühlwicklung mit einer festgelegten Geschwindigkeit bewegt wird, wobei die Bereiche des Halbeiterkörpers, welche noch nicht aufgeschmolzen worden sind, zunächst der Heizung und dann der Kühlung ausgesetzt werden. Die geschmolzene Zone hat dabei in jedem Augenblick senkrecht zur Wanderungsrichtung einen Querschnitt, welcher dem zuvor auf der einen Endfläche des Halbleiterkörpers aufgebrachten Muster entspricht. Während des Wanderns ist der Halbleiterkörper mindestens in dem Bereich, in dem sich die Schmelze gerade befindet, auf eine Temperatur im Bereich zwischen ungefähr 800 und 1400°C aufgeheizt und es hat sich herausgestellt, daß mit einem Temperaturgradienten in der Größenordnung von 50°C/cm gute Ergebnisse erzielt werden. Bei relativ dünnen Halbleiterkörpern, d. h, bei relativ kurzen Wanderstrecken, kann man auch so vorgehen, daß nach dem Aufbringen des Metallmusters auf die eine Oberfläche des Halbleiterkörpers der Halbleiterkörper in der Weise auf eine Temperatur oberhalb 800°C erhitzt wird, das die Oberfläche bis zu der die Schmelze wandern soll bzw. in deren Richtung die Schmelze wanderen soll, stärker erhitzt wird als die Oberfläche auf welche das Metallmuster aufgebracht worden ist. Der Temperaturunterschied zwischen den beiden Oberflächen wird unter Berücksichtigung des oben angegebenen Temperaturgradienten von 50°C/cm Abstand eingestellt. Dieser Temperaturgradient reicht als Antriebskraft aus, um die Schmelze durch den Halbleiterkörper wandern zu lassen. Die genaue Temperatur beim Migrationsverfahren wird so festgelegt, daß das Halbleitermaterial noch nicht, wohl aber das metallreiche Halbleitermaterial aufgrund seines durch den Metallzusatz erniedrigten Schmelzpunkts zum Schmelzen kommt. Zur Verhinderung einer lateralen Verbreiterung der Musterelemente beim Wandern wird als erste Maßnahme darauf geachtet, daß senkrecht zur Wanderungsrichtung der Temperaturgradient praktisch Null ist. Eine laterale Verbreitung der Musterelemente wird auch dadurch verhindert, daß beim Vorliegen einkristalliner Halbleiterkörper der Temperaturgradient und damit auch die Wanderungsrichtung in die $<100>$-, $<110>$- oder die $<111>$-Richtung gelegt wird. Bestehen die Muster aus geradlinigen Musterelementen, so ist es dabei zur Verhinderung der lateralen Verbreiterung weiter günstig, wenn bei einer Wanderung in die $<100>$-Richtung die Metallinien auf der (100)-Ebene aufgebracht sind und in der $<01\overline{1}>$- und $<0\overline{1}\overline{1}>$-Richtung verlaufen, bei einer Wanderung in der $<110>$-Richtung die Metallinien auf der $(1\overline{1}0)$-Ebene aufgebracht sind und in der $<1\overline{1}0>$-Richtung verlaufen und bei einer Wanderung in der $<111>$-Richtung die Metallinien auf der $(11\overline{1})$-Ebene aufgebracht sind und in den $<01\overline{1}>$-, $<\overline{1}01>$-, $<1\overline{1}0>$, $<11\overline{2}>$-, $<\overline{2}11>$- oder $<1\overline{2}1>$-Richtung verlaufen. Soll eine hochdotierte Struktur in dem Halbleiterkörper erzeugt werden, welche im Querschnitt senkrecht zur Wanderungsrichtung aus einem Gitter aus Linien besteht, welche in verschiedene Richtungen laufen, so ist es zur Vermeidung von Diskontinuitäten in der Struktur günstig, wenn man bei ihrer Herstellung mehrere Migrationsschritte anwendet und dabei bei einem Migrationsschritt jeweils nur Linien, welche in einer Richtung verlaufen, wandern läßt.

Sofern bei dem thermischen Migrationsprozeß entlang dem ganzen Migrationsweg die Festkörper-Sättigungskonzentration des P-Dotierungsmaterials im Substratmaterial erreicht wird, stellt sich innerhalb der Bereiche 7 eine im wesentlichen einheitliche Konzentration der Verunreinigung vom P-Typ ein.

Anschließend werden noch einmal Aluminiumlinien auf der Oberfläche der Epitaxieschicht 5 erzeugt. Dieses Mal werden die Linien so gebildet, daß sie in der kristallographischen $<1\overline{1}0>$-Richtung verlaufen. Das Aluminium wird wieder bevorzugt mittels einer Elektronenstrahlbedampfung auf der Epitaxieschicht 5 mit einer Dicke im Bereich zwischen ungefähr 3 und ungefähr 5 um aufgebracht. Anschließend wird die Photolackmaske erzeugt und dann wird das Aluminium unter Verwendung der entwickelten Maske geätzt, wobei die Aluminiumlinien 8, welche in der $<1\overline{1}0>$-Richtung auf der Oberfläche der Epitaxieschicht 5 zwischen den Subkollektorbereichen 4—wie es die Fig. 2A zeigt—verlaufen, übrigbleiben. Dann wird das Plättchen in die Vorrichtung für die thermische Migration gelegt und dort gelassen, bis die Aluminiumlinien unter Bildung von nicht gezeigten P-dotierten Bereichen vollständig durch das Plättchen hindurchgewandert sind. Die produzierten P-dotierten Bereiche sind ähnlich den in Fig. 2 gezeigten Bereichen 7, verlaufen jedoch senkrecht zu den Bereichen 7. Die Struktur besteht nun aus einer Matrix von einheitlich hochdotierten Bereichen vom P-Typ, welche die Lage der schließlich und endlich gewünschten Isolationsbereiche aus Siliciumdioxid festlegen.

Die hoch P-dotierten Bereiche werden nun in einer HF-Lösung anodisiert, wobei das Silicium in diesen Bereichen in eine poröse Siliciumstruktur umgewandelt werden. Typischerweise läßt man eine 12 %ige, wässrige HF-Lösung bei Raumtemperatur und bei einer Stromdichte von ungefähr 30 mA 20 Minuten lang auf das Plättchen einwirken. Dann wird das Plättchen ungefähr 30 Minuten lang bei ungefähr 970°C in Wasserdampf erhitzt, wobei die porösen Siliciumbereiche in die in der Fig. 3 gezeigten porösen Bereiche gaus Siliciumdioxid umgewandelt werden. Als Folge des Oxidationsschritts wird die Oberfläche des Plättchens auch mit einer ungefähr 150 nm dicken Oxidschicht bedeckt, welche anschließend—nach einem entsprechenden photolithographischen Ätzprozeß—als Maske beim Einführen von Verunreinigungen in die Struktur, wobei je nach Wunsch isolierte Halbleiterelemente in der Epitaxieschicht 5 gebildet werden, benutzt werden kann.

Bei der anhand der Fign. 1, 2 und 3 diskutierten Ausführungsform des erfindungsgemäßen Verfahrens wird der thermische Migrationsprozeß so lange durchgeführt, bis das P-dotierende Material, nämlich das Aluminium in dem Liniengitter, das Plättchen 1 vollständig, d. h. von der oberen Oberfläche 2 bis zu der unteren nicht gezeigten Oberfläche des Plättchens 1 durchdringt. Wie wohlbekannt und weiter oben beschrieben ist, wird bei dem thermischen Migrationsprozeß ein Zonenschmelzverfahren unter Aufrechterhaltung eines thermischen Gradienten angewandt, wobei eine geschmolzene Zone aus einem metallreichen Halbleitermaterial, wie z. B. aus aluminiumreichem Silicium, durch den Halbleiterkörper hindurchbewegt wird. In der in der Fig. 4 gezeigten Ausführungsform des erfindungsgemäßen Verfahrens jedoch, wird das Zonenschmelzverfahren unter Aufrechterhaltung eines thermischen Gradienten nur so lange praktiziert, bis die geschmolzene Zone aus mit Aluminium dotiertem Silicium die Tiefe der Linie 10 erreicht. Dann wird der thermische Gradient umgekehrt und die geschmolzene Zone wird durch den Körper 1 im wesentlichen entlang dem selben Weg zu der Oberfläche 2 zurückbewegt. Die porösen Siliciumdioxidbereiche 11 mit einer beschränkten Tiefe, werden in diesem Fall erhalten, nachdem die mittels des thermischen Migrationsprozesses erzeugten P-dotierten Zonen anodisiert (um poröses Silicium zu erhalten), und oxidiert (um poröses Siliciumdioxid zu erhalten) worden sind.

Alternativ kann der thermische Migrationsprozeß solange fortgesetzt werden, bis das Dotierungsmaterial vom P-Typ die in der Fig. 4 mit der gestrichelten Linie 12 umgegebenen Gebiete vollständig durchdringt. Die nicht oxidierten Bereiche unterhalb der Linie 10 und zwischen der gestrichelten Linie 12 in der Fig. 4, werden stark P-dotiert bleiben, wodurch Kanal-Stopbereiche unter jedem der Siliciumdioxidbereiche 11 bereitgestellt werden, welche die Bildung von unerwünschten Inversionskanälen verhindern, welche ansonsten unter den Siliciumdioxidbereichen 11 in dem $P^-$-dotierten Material, aus welchem das Substrat 1 besteht, in Erscheinung treten würden.

Obwohl in der obigen Beschreibung ein Siliciumplättchen beschrieben worden ist, dessen Hauptoberfläche eine (100)-Ebene ist, können auch Plättchen mit anderen Oberflächenorientierungen benutzt werden. Darauf wurde weiter oden hingewiesen. Es ist auch möglich, daß die mittels thermischer Migration erzeugten Bereiche in anderen Richtungen als den <1$\overline{1}$0>- und <110>-Richtungen ausgerichtet sind, was einfach dadurch erreicht wird, daß die Richtung der aufgebrachten Aluminiumlinien entsprechend orientiert wird. Auch dieser Punkt wurde weiter oben diskutiert. Darüber hinaus können auch andere Materialien als Aluminium als Dotierungsquelle für die thermische Migration verwendet werden. Geeignete Dotierungsmaterialien vom N-Typ für Silicium sind Phosphor, Arsen und Antimon. Geeignete Dotierungsmaterialien vom P-Typ für Silicium sind Bor, Aluminium Gallium und Indium. Jeder Überschuß des bei der thermischen Migration verwendeten Dotierungsmaterials, welcher auf einer der beiden Oberflächen des Halbleiterplättchens nach dem Abschluß des Migrationsprozesses zurückbleibt, muß vor der Durchführung der Anodisierungs- und Oxidationsprozeßschritte mittels eines geeigneten Ätzmittels entfernt werden.

**Patentansprüche**

1. Verfahren zum Herstellen einer Isolationsstruktur in einem einkristallinen Halbleiterkörper (1), welche sich von einer Oberfläche des Halbleiterkörpers (a) in diesen hinein erstreckt, wobei der herzustallenden Struktur entsprechende Bereiche des Halbleiterkörpers (1) hochdotiert, anschließend unter Umwandlung in poröses Halbleitermaterial anodisiert und schließlich oxidiert werden, dadurch gekennzeichnet, daß zum Dotieren auf einer Oberfläche des Halbleiterkörpers (1) ein dem Querschnitt der Isolationsstruktur parallel zu dieser Oberfläche entsprechendes Muster (6, 8) aus einem Metall erzeugt wird, das dann erhitzt wird, bis sich eine metallreiche Schmelze des Halbleitermaterials bildet, und man anschließend die dem Halbleiterkörper zugewandte Oberfläche der Schmelze unter Umwandlung von weiterem Halbleitermaterial in die metallreiche Schmelze in den Halbleiterkörper hineinwandern läßt, indem ein positiver Temperaturgradient in der gewünschten Wanderungsrichtung erzeugt wird.

2. Verfahren nach Anspruch 1, dadurch gekennzeichnet, daß ein aus Linien (6, 8) bestehendes Metallmuster auf einer (100)-Ebene des Halbleiterkörpers aufgebracht wird, wobei die Linien in der <110>- und/oder in der <1$\overline{1}$0>-Richtung verlaufen, und daß der Temperaturgradient in der <100>-Richtung erzeugt wird.

3. Verfahren nach Anspruch 2, dadurch gekennzeichnet, daß zunächst die in der einen Richtung verlaufenden Metallinien aufgebracht und anschließend die Schmelze erzeugt und der Migrationsprozeß durchgeführt wird und erst dann die Metallinien in der anderen Richtung aufgebracht und anschließend wie die zuerst aufgebrachten behandelt werden.

4. Verfahren nach einem oder mehreren der Ansprüche 1 bis 3, dadurch gekennzeichnet, daß Vorsorge getroffen wird, daß der Temperaturgradient senkrecht zur Wanderungsrichtung praktisch Null ist.

5. Verfahren nach einem oder mehreren der Ansprüche 1 bis 4, dadurch gekennzeichnet, daß als Metall Aluminium und als Halbleitermaterial Silicium verwendet werden.

6. Verfahren nach Anspruch 5, dadurch gekennzeichnet, daß das Aluminium in einer Dicke zwischen ungefähr 3 und ungefähr 5 $\mu$m aufgebracht wird.

7. Verfahren nach einem oder mehreren der Ansprüche 1 bis 6, dadurch gekennzeichnet, daß man die Schmelze vollständig durch den Halbleiterkörper (1) hindurchwandern läßt.

8. Verfahren nach einem oder mehreren der Ansprüche 1 bis 6, dadurch gekennzeichnet, daß man die Schmelze nur teilweise durch den Halbleiterkörper hindurchwandern läßt, indem man, wenn die gewünschte Tiefe erreicht ist, den Temperaturgradienten umkehrt.

9. Verfahren nach einem oder mehreren der Ansprüche 1 bis 8, dadurch gekennzeichnet, daß die Zeitdauer bei Anodisieren so gewählt wird, daß das hochdotierte Material nicht vollständig, sondern nur bis in eine festgelegte Tiefe (10) in poröses Silicium umgewandelt wird.

10. Verfahren nach einem oder mehreren der Ansprüche 1 bis 9, dadurch gekennzeichnet, daß die metallreiche Schmelze durch den Halbleiterkörper (1) in Form einer geschmolzenen Zone bewegt wird.

**Revendications**

1. Procédé pour la réaliation d'une structure d'isolation dans un corps semi-conducteur (1) monocristallin qui s'étend d'une surface du corps semi-conducteur (1) à l'intérieur de celui-ci, des zones du corps semi-conducteur (1) correspondant à la structure à réaliser étant fortement dopées, ensuite anodisées avec transformation simultanée en un matériau semi-conducteur poreux et, enfin, oxydées, caractérisé par le fait que, pour le dopage, un dessin (6, 8) correspondant à la section transversale de la structure d'isolation parallèle à la surface du corps semi-conducteur (1), est réalisé sur cette surface dans un métal qui est alors chauffé jusqu'à ce qu'il se forme une masse fondue du matériau semi-conducteur riche en métal; puis migration de la surface de la masse fondue vers le corps semi-conducteur, avec transformation simultanée d'un autre matériau semi-conducteur en une masse fondue riche en métal, à l'intérieur de ce corps semi-conducteur, en engendrant un gradient de température positif dans le sens de migration désiré.

2. Procédé selon la revendication 1, caractérisé par le fait qu'un dessin métallique composé de lignes (6, 8) est appliqué sur un plan (100) du corps semi-conducteur, les lignes s'étendant dans la direction <110> et/ou dans la direction <1$\overline{1}$0>, et qu'un gradient de température est engendré dans la direction <100>.

3. Procédé selon la revendication 2, caractérisé par le fait que ce sont les lignes métalliques, s'étendant dans l'une de directions, qui sont d'abord appliquées que l'on produit ensuite la masse fondue et que l'on effectue enfin le processus de migration; et ce n'est qu'après, que l'on applique les lignes métalliques dans l'autre direction et que l'on les traite ensuite comme celles appliquées en premier lieu.

4. Procédé selon l'une quelconque ou plusieurs des revendications 1 à 3, caractérisé par le fait que l'on veille à ce que le gradient de température, perpendiculaire au sens de migration, soit pratiquement égal à zéro.

5. Procédé selon l'une quelconque ou plusieurs des revendications 1 à 4, caractérisé par le fait que l'on utilise comme métal de l'aluminium et comme matériau semi-conducteur du silicium.

6. Procédé selon la revendication 5, caractérisé par le fait que l'aluminium est appliqué en une épaisseur comprise entre environ 3 et environ 5 $\mu$m.

7. Procédé selon l'une quelconque ou plusieurs des revendications 1 à 6, caractérisé par le fait que l'on fait migrer, complètement, la masse fondue à travers le corps semi-conducteur (1).

8. Procédé selon l'une quelconque ou plusieurs des revendications 1 à 6, caractérisé par le fait que l'on ne fait migrer la masse fondue que partiellement à travers le corps semi-conducteur en inversant le gradient de température lorsque lu profondeur désirée est atteinte.

9. Procédé selon l'une quelconque ou plusieurs des revendications 1 à 8, caractérisé par le fait que la durée de l'anodisation est choisie de telle sorte que le matériau fortement dopé n'est pas entièrement transformé en silicium poreux mais, seulement, jusqu'à une profondeur (10) déterminée.

10. Procédé selon l'une quelconque ou plusieurs des revendications 1 à 9, caractérisé par le fait que la masse fondue, riche en métal est transportée à travers le corps semi-conducteur (1) sous forme d'une zone fondue.

**Claims**

1. Method of making an isolation structure in a monocrystalline semiconductor body (1) which extends from a surface of the semiconductor body (1) into said body, regions of the semiconductor body (1) which correspond to the structure to be made being highly doped, subsequently anodized while being converted into porous semiconductor material, and finally oxidized, characterized in that for the doping on a surface of the semiconductor body (1) a pattern (6, 8) corresponding to the cross-section of the isolation structure in parallel to this surface is made of a metal which is subsequently heated until a metal-rich melt of the semiconductor material is formed, and in that subsequently the melt surface facing the semiconductor body is migrated, with further semiconductor material being converted into the metal-rich melt, into the semiconductor body in that a positive temperature gradient is produced in the desired migration direction.

2. Method as claimed in claim 1, characterized in that a metal pattern of lines (6, 8) is provided on a (100) plane of the semiconductor body, the lines extending in the <110> and/or in the <1$\overline{1}$0> direction, and in that the temperature gradient is produced in the <100> direction.

3. Method as claimed in claim 2, characterized in that first the metal lines in the one direction are applied and subsequently the melt is produced and the migration is effected, and that only then the metal lines in the other direction are applied, and subsequently treated like those applied first.

4. Method as claimed in any one or several of claims 1 to 3, characterized in that steps are taken to the effect that the temperature gradient perpendicularly to the migration direction is practically zero.

5. Method as claimed in any one of several of claims 1 to 4, characterized in that as the metal aluminum, and as the semiconductor material silicon is used.

6. Method as claimed in claim 5, characterized in that the aluminum is applied in a thickness between approximately 3 and approximately 5 μm.

7. Method as claimed in any one or several of claims 1 to 6, characterized in that the melt is migrated completely through the semiconductor body (1).

8. Method as claimed in any one or several of claims 1 to 6, characterized in that the melt is migrated only partially through the semiconductor body in that when the desired depth has been reached the temperature gradient is reversed.

9. Method as claimed in any one of several of claims 1 to 8, characterized in that the anodizing period is selected in such a manner that the highly doped material is converted into porous silicon not completely but only up to a predetermined depth (10).

10. Method as claimed in any one of several of claims 1 to 9, characterized in that the metal-rich melt is migrated through the semiconductor body (1) in the form of a molten zone.

FIG. 1

FIG. 1A

FIG. 2

FIG. 2A

FIG. 3

FIG. 4